Europäisches Patentamt

European Patent Office

Office européen des brevets

(11) Publication number: **0 070 615**
**B1**

(12) **EUROPEAN PATENT SPECIFICATION**

(45) Date of publication of patent specification: **09.09.87**

(21) Application number: **82302591.1**

(22) Date of filing: **20.05.82**

(51) Int. Cl.⁴: **H 05 K 7/14**

(54) Circuit board module mounting units.

(30) Priority: **22.07.81 US 286106**

(43) Date of publication of application:
**26.01.83 Bulletin 83/04**

(45) Publication of the grant of the patent:
**09.09.87 Bulletin 87/37**

(84) Designated Contracting States:
**DE GB IT**

(56) References cited:
**DE-A-2 714 562**
**US-A-3 465 891**

(73) Proprietor: **THE BABCOCK & WILCOX COMPANY**
**1010 Common Street P.O. Box 60035**
**New Orleans Louisiana 70160 (US)**

(72) Inventor: **Stockmaster, Edward F.**
**4812 Homewood Drive**
**Mentor Ohio 44060 (US)**

(74) Representative: **Cotter, Ivan John et al**
**D. YOUNG & CO. 10 Staple Inn**
**London WC1V 7RD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

The present invention relates to circuit board module mounting units.

Complex and large electric circuit networks such as systems control networks for power stations and nuclear reactors are typically broken down into a plurality of small circuits each mounted on a modular printed circuit board. The printed circuit boards, which are electrically interconnected to make up the network, enable fast and easy replacement of failed network components as well as providing flexibility of design.

Printed circuit boards are typically rectangular and are mounted vertically in racks. Generally, the top and bottom edges of the boards slide in tracks and the back edge is equipped with some electrical connector means.

The front of the printed circuit board module is equipped with a plate for handling, identification and aesthetic purposes. Also, some mechanism is typically provided to lock the circuit board module to the circuit board rack. This is desired to prevent withdrawal of the module and thereby breaking of the circuit network in the event of some withdrawal force being applied to the circuit board by accident.

Known racks for retaining such printed circuit board modules were usually trays made from a series of various custom parts, were not reversible and were expensive to manufacture.

German Patent Application Publication No. DE—A—2 714 562 describes a circuit board mounting unit in which two side plates are separated by brackets mounted between each corner of the side plates. Channel strips are parallel-mounted across the brackets to act as guides for the circuit boards. The brackets include transverse rectangular slots for receiving retaining tabs on the channels strips so as to retain the channel strips in position.

According to the present invention there is provided a module mounting unit for mounting a series of circuit board control modules, the unit comprising:

a pair of side plates;

a first bracket mounted between lower front corners of the pair of side plates to have a series of apertures along a face of the bracket;

a second bracket mounted between upper front corners of the pair of side plates; and

at least one pair of channel strips parallel-mounted to form guideways for the circuit boards of the circuit board control modules; characterised by:

a series of support brackets for the channel strips, the support brackets being spacedly-mounted between the side plates and parallel to the first and second brackets, and each having a series of spaced alternating circular and oval holes along one face thereof, the channel strips being parallel-mounted across the support brackets and each being retained by alternate circular and oval holes in adjacent support brackets.

A module mounting unit constituting a preferred embodiment of the present invention and described in detail hereinbelow can overcome or at least alleviate the disadvantages of the prior art devices in that it is assembled from two different pieces, making it easy to manufacture and assemble as well as inexpensive and is, furthermore, reversible so that the entire unit may be mounted on either side. The preferred module mounting unit is made from a pair of identical side plates. The side plates are separated by a series of identical brackets, each of which provide a series of mounting apertures for retaining the control modules within the module mounting unit as well as providing a series of guideway mounting apertures for easily mounting a series of circuit board guideways across the series of brackets to provide guideways or slides for sliding the circuit boards of the circuit board control modules therein.

Each bracket of the preferred module mounting unit is formed as a U-shaped channel and one leg of the U-shaped channel has a series of spaced circular apertures while the bottom or well of the U-shaped channel has a series of spaced alternating circular and oval apertures. The front and back mounting of the U-shaped channels between the pair of side plates is done so as to have the series of circular apertures along the leg of the U-shaped bracket facing out to accept a tab on the face of the circuit board control module to thus lock the circuit board control module into the module mounting unit.

The well or bottom of the U-shaped bracket of the preferred module mounting unit has a series of alternately-spaced circular and oval apertures used for mounting the guideways for sliding the circuit board of the circuit board control module therein. One end of the well starts with a circular hole and ends with an oval hole. Rotating the middle bracket through 180° allows a circular hole to be in line with adjacent oval holes of the adjoining brackets. The guideways are strips having three push-in tabs which may be pushed into the middle bracket's circular hole and the oval holes of the adjoining bracket to allow any tolerance variations on the tab locations on the guideways to be compensated for by movement within the oval apertures of the adjacent brackets.

In view of the foregoing, it will be seen that the preferred module mounting unit is simple and inexpensive to construct, and that a variation in the uses of the individual identical parts of the module mounting unit is possible by simple alignment and rotation of the individual parts.

The invention will now be further described, by way of illustrative and non-limiting example, with reference to the accompanying drawing, in which:

Figure 1 is a perspective view of a module mounting unit embodying the present invention, showing a circuit board module partially inserted therein;

Figure 2 is an expanded view of guideway mounting brackets of the modular mounting unit of Figure 1; and

Figure 3 is a cross-sectional side view of the modular mounting unit taken along a section A—A in Figure 1 and showing the circuit board module fully inserted into the module mounting unit.

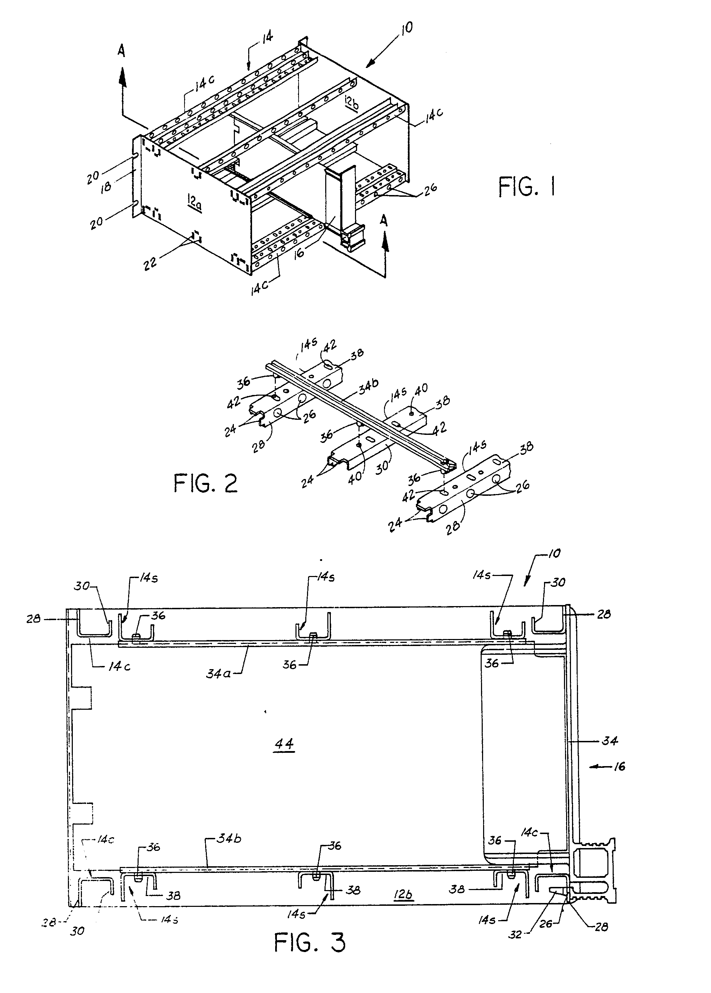

Figures 1 and 3 show a module mounting unit 10 which is constructed from a pair of identical side plates 12a, 12b and a series of identical U-shaped cross-members 14. The module mounting unit 10 is intended to mount twelve circuit board control modules 16 in a side-by-side arrangement. For the sake of simplicity, only one module 16 is shown but it will be understood that the mounting of an additional eleven modules 16 would be accomplished in a similar manner as will be described with reference to the single module 16 shown.

The module mounting unit 10 is intended for mounting in known system cabinets. Such system cabinets are front and rear access units to allow simplified installation and servicing. Standard blower assemblies are mounted inside the cabinet for cabinet cooling.

It will be seen from Figure 1 that the side plates 12a and 12b are identical, the side plate 12b being the same as the side plate 12a rotated through 180°. Although only the side plate 12a will be described, it will be understood that all the elements found in the side plate 12a also appear in the side plate 12b. With this in mind, the side plate 12a has a flange 18 with a pair of slots 20 used to mount the module mounting unit 10 within the system cabinet by way of large head screws. The side plate 12a has a series of elongate slots 22 into which tabs 24 of the individual U-shaped cross-members 14 fit. The tabs 24, after being fitted into the elongate slots 22, are welded therein to form the module mounting unit 10.

Each U-shaped cross-member 14 has twelve spaced apertures or holes 26 along a longer leg portion 28 of its U-shaped cross-section. A shorter leg portion 30 of each cross-member 14 is solid (imperforate) to provide strength and rigidity. Four of the U-shaped cross-members 14 are mounted at respective ones of the corners of the side plates 12a and 12b to act as corner cross-members 14c. The corner cross-members 14c are mounted to have the longer leg portions 28 facing out from the module mounting unit 10, as shown in Figure 3. The apertures 26 are used to press a tab 32, having a prong with a tapered head, extending from a face or front panel 34 of each circuit board control module' 16 therein to thus retain the circuit board control module inside of the module mounting unit 10. The twelve holes 26 on each longer leg portion 28 of each cross-member 14 are spaced to allow twelve circuit board control modules 16 to be thus attached to the module mounting unit 10. The corner cross-members 14c located at the rear of the module mounting unit 10 also have their longer leg portions 28 extending out from the module mounting unit to allow a known cable connection panel or termination unit to be mounted to the holes 26 (or other holes provided there in a well-known manner) to thus provide input and output signals from the twelve circuit board control modules 16.

Circuit board guideways 34a, 34b are mounted across three support U-shaped cross-members 14s spacedly mounted between the side plates 12a and 12b to allow push-in tabs 36 extending from the bottom of each guideway 34 to be pressed into apertures located along a bottom or base portion 38 of each U-shaped cross-member 14.

With particular reference to Figure 2, each U-shaped cross-member 14 is seen to have a series of alternating circular apertures 40 and oval apertures 42 in its base portion 38. Each cross-member 14 has an oval aperture 42 as the first aperture at one end and a circular aperture 40 as the last aperture at the other end. Thus, rotation of the middle support cross-member 14s through 180° provides that the first aperture on the middle support member 14s is a circular aperture 40 and that the first apertures on the two support members 14s adjoining it are oval apertures 42. The guideway 34b is mounted across the three support members 14s by pressing the middle tab 36 into the circular aperture 40 and the end tabs 36 into the adjoining oval apertures 42. The oval apertures 42 allow any tolerance variations to be accommodated by the extended length of the oval apertures 42. It will be understood that, in this manner, twelve bottom guideways 34b may be pressed into the modular mounting unit as well as twelve top guideways 34a directly above the bottom-mounted guideways 34b. A circuit board portion 44 of each circuit board control module 16 is thus easily slid into the modular mounting unit 10 to have the card portion 44 located between the guideways 34a and 34b.

**Claims**

1. A module mounting unit (10) for mounting a series of circuit board control modules (16), the unit comprising:

a pair of side plates (12a, 12b);

a first bracket (14c) mounted between lower front corners of the pair of side plates (12a, 12b) to have a series of apertures (26) along a face of the bracket;

a second bracket (14c) mounted between upper front corners of the pair of side plates (12a, 12b); and

at least one pair of channel strips (34a, 34b) parallel-mounted to form guideways for the circuit boards (44) of the circuit board control modules (16);

characterised by:

a series of support brackets (14s) for the channel strips (34a, 34b), the support brackets (14s) being spacedly-mounted between the side plates (12a, 12b) and parallel to the first and second brackets (14c), and each having a series of spaced alternating circular and oval holes (40, 42) along one face (38) thereof, the channel strips (34a, 34b) being parallel-mounted across the support brackets (14s) and each being retained by alternate circular and oval holes (40, 42) in adjacent support brackets (14s).

2. A module mounting unit according to claim 1, wherein each of the circuit board control modules (16) includes a printed circuit board (44) connected to a front panel (34) having a tab member (32) extending therefrom, the printed circuit board (44) being slidable in the channel strips (34a, 34b) to locate the control module (16) in the module mounting unit (10) and the tab member (32) being pressable into one of the series of apertures (26) along the face of the first bracket (14c) to retain the control module (16) in the module mounting unit (10).

3. A module mounting unit according to claim 1 or claim 2, including a pair of rear mounting brackets (14c) located at rear top and bottom portions of the side plates (12a, 12b) to extend between the side plates with a series of apertures (26) extending along faces of the pair of rear mounting brackets for mounting a control module signal connection panel thereto.

4. A module mounting unit according to claim 1, claim 2 or claim 3, wherein the series of support brackets (14s) includes three top-mounted and three bottom-mounted support brackets equally spaced along the length of the pair of side plates (12a, 12b) with each bracket (14s) having a series of alternately-spaced circular holes (40) and oval holes (42).

5. A module mounting unit according to claim 4, wherein a circular hole (40) on the middle bracket of the three top-mounted and three bottom-mounted support brackets (14s) is aligned with oval holes (42) of the adjoining brackets and wherein each of the series of channel strips (34a, 34b) has three mounting tabs (36) connectable to the circular hole (40) and the adjoining oval holes (42) of the series of support brackets (14s).

6. A module mounting unit according to any one of the preceding claims, wherein the second bracket (14c) is identical to the first bracket (14c) to make the module mounting unit 180° reversible.

7. A module mounting unit according to claim 1, claim 2 or claim 3, wherein each of the support brackets (14s) and the first and second brackets (14c) is formed as a U-shaped channel having a series of equally-spaced circular apertures (26) along one leg thereof and a series of equally-spaced alternating circular holes (40) and oval holes (42) along the base portion (38) thereof beginning with a circular hole (40) at one end of the base portion (38) and ending with an oval hole (42) at the other end thereof.

8. A module mounting unit according to claim 7, wherein alternate support brackets of the series of support brackets (14s) are 180° rotated to align an oval hole (42) on one support bracket with a circular hole (42) on an adjoining support bracket.

9. A module mounting unit according to any one of the preceding claims, wherein each bracket (14c, 14s) has a pair of tab members (24) at opposite ends thereof and each of the pair of side plates (12a, 12b) has a series of elongate slots (22) therein for receiving the tab members (24) to thus align the brackets.

10. A module mounting unit according to claim 9, wherein the tab members (24) are welded to the pair of side plates (12a, 12b).

**Patentansprüche**

1. Baugruppenaufnahmeeinheit (10) zur Aufnahme einer Reihe von Leiterplattensteuerbaugruppen (16), mit
einem Paar von Seitenplatten (12a, 12b);
einer ersten Klammer (14c), welche zwischen den unteren vorderen Ecken des Paares von Seitenplatten (12a, 12b) angebracht ist und eine Reihe von Öffnungen (26) entlang einer Fläche der Klammer hat;
einer zweiten Klammer (14c), welche zwischen den oberen vorderen Ecken des Paares von Seitenplatten (12a, 12b) befestigt ist; und
zumindest einem Paar von Schlitzstreifen (34a, 34b), welche parallel befestigt sind, um Führungsbahnen für die Leiterplatten (44) der Leiterplattensteuereinheiten (60) zu bilden;
gekennzeichnet durch:
eine Reihe von Stützklammern (14s) für die Schlitzstreifen (34a, 34b), wobei die Stützklammern (14s) im Abstand und zwischen den Seitenplatten (12a, 12b) und parallel zu den ersten und zweiten Klammern (14c) befestigt sind und jeweils eine Reihe von beabstandeten abwechselnd kreisförmigen und ovalen Löchern entlang einer ihrer Flächen (38) haben, wobei die Schlitzstreifen (34a, 34b) parallel über die Stützklammern (14s) befestigt sind und jeder abwechselnd durch ein kreisförmiges und ein ovales Loch (40, 42) in benachbarten Stützklammern (14s) gehalten wird.

2. Baugruppenaufnahmeeinheit nach Anspruch 1, wobei jede der Leiterplattensteuerbaugruppen (16) eine gedruckte Leiterplatte (44) aufweist, welche mit einer Frontplatte (34) verbunden ist, welche einen Zapfenteil (32) aufweist, der sich von dieser erstreckt, wobei die gedrückte Schaltkarte bzw. Leiterplatte (44) gleitbar in den Schlitzstreifen (34a, 34b) ist, um die Steuerbaugruppe (16) in der Baugruppenaufnahmeeinheit (10) zu lokalisieren, und das Zapfenteil (32) in eine aus der Reihe von Öffnungen (26) entlang der Fläche der ersten Klammer (14c) eindrückbar ist, um die Steuerbaugruppe (16) in der Baugruppenaufnahmeeinheit (10) zu halten.

3. Baugruppenaufnahmeeinheit nach Anspruch 1 oder 2, mit einem Paar von hinteren Befestigungsklammern (14c), welche an den hinteren oberen und unteren Teilen der Seitenplatten (12a, 12b) angeordnet sind und sich zwischen den beiden Platten erstrecken, mit einer Reihe von Öffnungen (26), welche sich entlang der Flächen des Paares von hinteren Befestigungsklammern für die Befestigung einer Steuerbaugruppensignalverbindungsplatte daran erstrecken.

4. Baugruppenaufnahmeeinheit nach Anspruch 1, 2 oder 3, wobei die Reihe von Stützklammern (14s) drei oben und drei unten befestigte Stützklammern einschließt, welche in gleichem Abstand entlang der Länge des Paares von Seitenplatten (12a, 12b) sind, wobei jede Klammer (14s) eine Reihe von beabstandeten abwechselnd kreisförmigen Löchern (40) und ovalen Löchern (42) hat.

5. Baugruppenaufnahmeeinheit nach Anspruch 4, wobei ein kreisförmiges Loch (40) auf der mittleren Klammer der drei oben befestigten und der drei unten befestigten Stützklammern (14s) mit ovalen Löchern (42) auf den benachbarten Klammern ausgerichtet ist und wobei jede der Serien von Schlitzstreifen (34a, 34b) drei Befestigungszapfen (36) hat, welche mit dem kreisförmigen Loch (40) und den benachbarten ovalen Löchern (42) der Reihen von Stützklammern (14s) verbindbar sind.

6. Baugruppenaufnahmeeinheit gemäß einem der vorstehenden Ansprüche, wobei die zweite Klammer (14c) mit der ersten Klammer (14c) identisch ist, so daß die Baugruppenaufnahmeeinheit um 180° umkehrbar ist.

7. Baugruppenaufnahmeeinheit nach Anspruch 1, 2 oder 3, wobei jede der Stützklammern (14s) und die ersten und zweiten Klammern (14c) als U-förmiger Kanal ausgebildet sind, welcher eine Reihe von in gleichem Abstand angeordneten kreisförmigen Öffnungen (26) entlang seines einen Schenkels und eine Reihe von im gleichen Abstand angeordneten abwechselnd kreisförmigen Löchern (40) und ovalen Löchern (42) entlang seines Basisteiles (38) hat, beginnend mit einem kreisförmigen Loch (40) an einem Ende des Basisteiles (38) und endend mit einem ovalen Loch (42) an dessen anderem Ende.

8. Baugruppenaufnahmeeinheit nach Anspruch 7, wobei abwechselnde Stützklammern der Reihen von Stützklammern (14s) um 180° gedreht sind, um ein ovales Loch (42) auf einer Stützklammern mit einem kreisförmigen Loch (42) auf einer benachbarten Stützklammern auszurichten.

9. Baugruppenaufnahmeeinheit gemäß einem der vorstehenden Ansprüche, wobei jede Klammer (14c, 14s) ein Paar von Zapfenteilen (24) an gegenüberliegenden Enden aufweist und wobei jede des Paares von Seitenplatten (12a, 12b) eine Reihe von länglichen Schlitzen (22) aufweist zur Aufnahme der Zapfenteile (24), um so die Klammern auszurichten.

10. Baugruppenaufnahmeeinheit nach Anspruch 9, wobei die Zapfenteile (24) an dem Paar von Seitenplatten (12a, 12b) angeschweißt sind.

**Revendications**

1. Ensemble (10) de montage de modules pour le montage d'une série de modules de commande (16) à plaques de circuits, l'ensemble comprenant:

deux plaques latérales (12a, 12b);

un premier tasseau (14c) monté entre les coins inférieurs avant des deux plaques latérales (12a, 12b) pour présenter une série d'orifices (26) le long d'une de ses faces;

un second tasseau (14c) monté entre les coins supérieurs avant des deux plaques latérales (12a, 12b); et

au moins une paire de barres en U (34a, 34b) montées parallèlement pour constituer des glissières pour les plaques de circuits (44) des modules de commande (16);

caractérisé par:

une série de tasseaux de support (14s) pour les barres en U (34a, 34b), les tasseaux de support (14s) étant montés à intervalles entre les plaques latérales (12a, 12b) et parallèlement au premier et econd tasseaux (14c) et présentant chacun une série de trous circulaires et ovales alternants (40, 42) espacés le long d'une de leurs faces (38), les barres en U (34a, 34b) étant montées parallèlement en travers des tasseaux de support (14s) et étant retenues chacune par des trous circulaires et ovales alternés (40, 42) de tasseaux de support (14s) voisins.

2. Ensemble de montage de modules selon la revendication 1, dans lequel chacun des modules de commande (16) comporte une plaque de circuits imprimés (44) reliée à un panneau avant (34) présentant une patte dépassante (32), la plaque de circuits imprimés (44) pouvant coulisser dans les barres en U (34a, 34b) pour positionner le module de commande (16) dans l'ensemble (10) de montage de modules et la patte (32) pouvant être introduite par pression dans l'un des orifices (26) de la série longeant la face du premier tasseau (14c) pour maintenir le module de commande (16) dans l'ensemble (10) de montage de modules.

3. Ensemble de montage de modules selon la revendication 1 ou 2, comportant deux supports de montage arrière (14c) situés dans les parties supérieures et inférieures arrière des plaques latérales (12a, 12b) pour s'étendre entre les plaques latérales, une série d'orifices (26) longeant les faces des deux supports de montage arrière pour le montage sur celui-ci d'un panneau de connexion de signal de module de commande.

4. Ensemble de montage de modules selon l'une quelconque des revendications 1 à 3, dans lequel la série de tasseaux de support (14s) comporte trois tasseaux de support montés en haut et trois tasseaux de support montés en bas équidistants sur la longueur des deux plaques latérales (12a, 12b), chaque tasseau (14s) présentant une série de trous circulaires (40) et ovales (42) alternativement espacés.

5. Ensemble de montage de modules selon la revendication 4, dans lequel un trou circulaire (40) du tasseau médian des trois tasseaux de support montés en haut et des trois tasseaux de support montés en bas (14s) est aligné avec des trous ovales (42) des tasseaux voisins, et dans lequel chacune des barres en U de la série (34a, 34b) présente trois pattes de montage (36) pouvant être reliées au trou circulaire (40) et aux trous ovales voisins (42) de la série de tasseaux de support (14s).

6. Ensemble de montage de modules selon l'une quelconque des revendications précédentes, dans lequel le second tasseau (14c) est identique au premier tasseau (14c) pour que l'ensemble de montage de modules puisse être retourné de 180°.

7. Ensemble de montage de modules selon l'une quelconque des revendications 1 à 3, dans lequel chacun des tasseaux de support (14s) et des premier et second tasseaux (14c) est façonné sous forme de gouttière à profil en U présentant une série de trous circulaires équidistants (26) située le long d'une de ses ailes, et une série de trous circulaires (40) et ovales (42) alternants espacés située le long de son embase (38) commençant par un trou circulaire (40) situé à une extrémité de l'embase (38) et se terminant par un trou ovale (42) situé à l'autre extrémité de celle-ci.

8. Ensemble de montage de modules selon la revendication 7, dans lequel des tasseaux de support alternés de la série de tasseaux de support (14s) sont tournés de 180° pour aligner un trou ovale (42) d'un tasseau de support avec un trou circulaire (42) d'un tasseau de support voisin.

9. Ensemble de montage de modules selon l'une quelconque des revendications précédentes, dans lequel chaque tasseau (14c, 14s) présente une paire de pattes (24) à ses extrémités opposées, et chacune des deux plaques latérales (12a, 12b) présente une série de fentes oblongues (22) pour recevoir les pattes (24) afin d'aligner ainsi les tasseaux.

10. Ensemble de montage de modules selon la revendication 9, dans lequel les pattes (24) sont soudées aux deux plaques latérales (12a, 12b).

FIG. 1

FIG. 2

FIG. 3